# EUROPÄISCHE PATENTSCHRIFT

(11) **EP 0 468 396 B1**
(45) Veröffentlichungstag und Bekanntmachung des Hinweises auf die Patenterteilung: **29.06.1994**
(21) Anmeldenummer: 91112231.5
(22) Anmeldetag: 22.07.1991
(51) Int. Cl.: C23C 16/18, C07F 1/08, C07F 9/02

(54) **Verfahren zur Abscheidung einer Kupfer enthaltenden Schicht I**
Process for depositing a copper-containing layer
Procédé pour déposer une couche contenant du cuivre

(30) Priorität: 27.07.1990 DE 4023879; 06.07.1991 DE 4122449
(43) Veröffentlichungstag der Anmeldung: 29.01.1992
(73) Patentinhaber: Kali-Chemie Aktiengesellschaft, D-30173 Hannover (DE)
(72) Erfinder: Kruck, Thomas, W-5024 Erftstadt-Bliesheim (DE); Terfloth, Christian, W-5000 Köln 41 (DE)
(74) Vertreter: Lauer, Dieter, Dr.

(56) Entgegenhaltungen:
- EP-A- 0 135 179
- EP-A- 0 297 348
- US-A- 3 594 216
- JOURNAL OF THE AMERICAN CHEMICAL SOCIETY, vol. 96, no. 18, 4 September1974, US, pp. 5930-5931; T. TSUDA ET AL: "T-BUOCU.CO AND T-BUOCU.CN-T-BU. NEW AND DUBLIMABLE COPPER-CARBONYL AND -ISOCYANIDE COMPLEXES"
- JOURNAL OF THE AMERICAN CHEMICAL SOCIETY, vol. 94, no. 2, 26 January 1974, US, pp. 658-659; T. TSUDA ET AL: "CUPROUS TERT-BUTOXIDE. A NEW ANDUSEFUL METALATION REAGENT"

## Beschreibung

Die Erfindung bezieht sich auf ein Verfahren zur Abscheidung einer Kupfer enthaltenden Schicht auf einem Substrat sowie neue, im erfindungsgemäßen Verfahren einsetzbare Kupferverbindungen.

Es ist bekannt, Substrate durch Oberflächenbeschichtung so zu modifizieren, daß ihre Oberfläche bestimmte funktionale Eigenschaften aufweist. Beispielsweise kann man den elektrischen Strom leitende Schichten, z.B. Leiterbahnen auf Substraten aufbringen.

Aufgabe der vorliegenden Erfindung ist es, ein Verfahren zur Abscheidung einer Kupfer enthaltenden Schicht auf einem Substrat anzugeben. Aufgabe der vorliegenden Erfindung ist es weiterhin, neue Kupferverbindungen anzugeben, die im erfindungsgemäßen Verfahren einsetzbar sind. Diese Aufgabe wird durch das erfindungsgemäße Verfahren und die im erfindungsgemäßen Verfahren einsetzbaren Kupferverbindungen der allgemeinen Formel (I) gelöst.

Das erfindungsgemäße Verfahren zur Abscheidung einer Kupfer enthaltenden Schicht auf einem Substrat ist dadurch gekennzeichnet, daß man durch Zersetzung einer Verbindung der allgemeinen Formel RO-Cu-L (I), worin R für 1-Arylniedrigalkyl, insbesondere Benzyl; für verzweigtes, gegebenenfalls substituiertes Alkyl mit 3 bis 6 C-Atomen; Aryl, insbesondere Phenyl, oder substituiertes Phenyl, insbesondere Tolyl oder Mesityl und L für (C1-C6-Alkyl)-isonitril, insbesondere verzweigtes Alkylisonitril mit 3 bis 5 C-Atomen in der Alkylkette oder Arylisonitril, insbesondere Phenylisonitril oder Tolylisonitril, Kohlenmonoxid, Dialkylaminodifluorphosphan, Organyldifluorphosphan, insbesondere Phenyldifluorphosphan oder t-Butyldifluorphosphan, Triarylphosphan oder Trialkylphosphan oder Trifluorphosphan oder Trichlorphosphan steht, eine Kupfer enthaltende Schicht auf dem Substrat aufbringt.

Bevorzugt bedeutet R verzweigtes Alkyl mit 3 bis 5 C-Atomen, insbesondere i-Propyl, i-Butyl, t-Butyl oder neo-Pentyl, oder für verzweigtes, durch 1 oder mehr Fluoratome substituiertes Alkyl mit 3 bis 5 C-Atomen, insbesondere 2-Trifluormethylpropyl oder Perfluor-t-butyl.

Bevorzugt bedeutet L t-Butylisonitril, Kohlenmonoxid, Triphenylphosphan oder Tri(niedrigalkyl)phosphan, insbesondere Trimethylphosphan oder Triethylphosphan, oder Trifluorphosphan.

Zur Abscheidung einer Kupfer enthaltenden Schicht kann der Fachmann die Abscheidung aus der kondensierten Phase oder aus der Gas- bzw. Dampfphase vornehmen. Für den Fachmann ist dabei selbstverständlich, daß er nicht nur eine bestimmte Verbindung der allgemeinen Formel (I), sondern auch Gemische solcher Verbindungen einsetzen kann.

Zur Abscheidung aus der kondensierten Phase bringt der Fachmann die Verbindung der Formel (I) ohne Lösungsmittel oder vorzugsweise in einem Lösungsmittel gelöst auf dem Substrat auf und zersetzt die Verbindung. Als Lösungsmittel können polare oder unpolare, aprotische organische Lösungsmittel, die gewünschtenfalls koordinierende Eigenschaften aufweisen können, verwendet werden. Geeignet sind beispielsweise aliphatische Kohlenwasserstoffe wie Pentan oder Petrolbenzin, aromatische Kohlenwasserstoffe wie Benzol oder Toluol oder Ether wie Tetrahydrofuran.

Um die jeweilige Ausgangsverbindung auf dem Substrat aufzubringen, kann man sich bekannter Methoden bedienen, beispielsweise kann man das Substrat in die Verbindung oder eine entsprechende Lösung eintauchen, man kann die Ausgangsverbindung oder eine entsprechende Lösung auf dem Substrat aufstreichen oder, bevorzugt, die Verbindung oder eine entsprechende Lösung auf das Substrat aufsprühen.

Mittels dieser Ausführungsform des erfindungsgemäßen Verfahrens, nämlich dem Aufbringen der Ausgangsverbindung (bzw. einem entsprechenden Gemisch von Ausgangsverbindungen) aus der kondensierten Phase, gelingt es, auch große Flächen sehr schnell zu beschichten.

Dann erfolgt die Zersetzung der auf dem Substrat aufgebrachten Ausgangsverbindung zur Abscheidung einer Kupfer enthaltenden Schicht, gewünschtenfalls unter vermindertem Druck. Bevorzugt bewirkt man die Zersetzung thermisch.

Dies kann durch Einbringen des mit der Ausgangsverbindung beschichteten Substrats in eine entsprechend beheizte Kammer, durch Heizen des Substrats vor, während und/oder nach dem Aufbringen der Ausgangsverbindung auf den angegebenen Temperaturbereich erfolgen.

Die thermische Zersetzung kann auch strahlungsinduziert bewirkt werden, beispielsweise durch einen Laser, der im UV-Bereich, im Infrarot-Bereich oder im Bereich des sichtbaren Lichts arbeitet und den Träger aufheizt.

Gewünschtenfalls kann die Zersetzung auch durch Photolyse erfolgen. Die photolytische Zersetzung kann durch einen bei der entsprechenden Wellenlänge betriebenen Laser oder einer UV-Lampe bewirkt werden.

Die Zersetzung kann man auch plasmainduziert durchführen. Hierzu eignen sich die verschiedenen bekannten Verfahren.

Beispielsweise kann man ein thermisches Plasmaverfahren, z.B. Lichtbogenplasma oder Plasmajet, anwenden. Der Druck liegt dann üblicherweise zwischen 1,3 mbar (10 Torr) und Normal druck.

Gut geeignet sind insbesondere auch Niederdruckplasmaverfahren, z.B. Gleichstromplasmaverfahren, Glimmentladungsplasmaverfahren und Wechselstromplasmaverfahren, z.B. Niederfrequenz-, Mittelfrequenz-, Hochfrequenzplasmaverfahren und Mikrowellenplasmaverfahren. Man arbeitet üblicherweise bei Drucken unterhalb 10 mbar, beispielsweise zwischen 10⁻² und 1 mbar. Die plasmainduzierte Zersetzung erfolgt in bekannten Plasmareaktoren. Verwendbar sind beispielsweise Rohr-, Tunnel-, Parallelplatten- und und Coronaentladungsreaktoren. Da die Zersetzung im Plasma gewünschtenfalls bei niedrigen Temperaturen durchgeführt werden kann, ist die Zersetzung im Plasma gut geeignet zur Beschichtung von Sub straten mit verhältnismäßig geringerer Thermostabilität, beispielsweise für Beschichtung von Kunststoffen.

Der Fachmann kann durch Zusatz eines Reaktivgases die Form, in welcher das Kupfer in der Schicht vorliegt, beeinflussen. Dies, sowie die Möglichkeit der gleichzeitigen Abscheidung anderer Metalle oder der sukzessiven Abscheidung weiterer, insbesondere weiterer Schichten mit anderer Zusammensetzung, wird noch erläutert.

Eine andere Ausführungsform des erfindungsgemäßen Verfahrens betrifft die Zersetzung der Ausgangsverbindung in der Gas- bzw. Dampfphase. In der Dampfphase sind neben der gasförmigen vorliegenden Ausgangsverbindung auch noch Anteile der kondensiert vorliegenden Ausgangsverbindung in feinster Verteilung enthalten. Die Abscheidung aus der Gas- bzw. Dampfphase ermöglicht die Abscheidung besonders gut haftender, gleichmäßiger, dünner Schichten.

Der Druck in der Dampfphase bzw. Gasphase kann mehr oder weniger hoch sein. Man kann beispielsweise bei einem Druck arbeiten, der dem Dampfdruck der verwendeten Ausgangsverbindung bei der Arbeitstemperatur entspricht. Der Gesamtdruck kann aber auch höher sein, bis hin zum Normaldruck. Zweckmäßig arbeitet man bei vermindertem Druck, beispielsweise bei 10⁻² bis 10 mbar, vorzugsweise bei 0,1 bis 1 mbar.

Die Zersetzung der Ausgangsverbindung in der Dampfphase oder Gasphase führt man zweckmäßig nach Art eines CVD(Chemical-Vapour-Deposition)-Verfahrens durch.

Die prinzipielle Vorgehensweise zur Beschichtung von Substraten unter Anwendung von CVD-Verfahren sowie geeigneter Apparaturen dafür sind bekannt. Die EP-A 297 348 (die sich mit ähnlichen Beschichtungen befaßt wie die vorliegende Erfindung) gibt dem Fachmann ausführliche Hinweise, wie ein CVD-Verfahren durchzuführen ist und welche Apparaturen verwendbar sind.

Die Zersetzung aus der Gas- bzw. Dampfphase wird zweckmäßig in einer druckfesten, evakuierbaren Vorrichtung durchgeführt. In diese Vorrichtung wird das zu beschichtende Substrat eingebracht. Bei vermindertem Druck wird eine Atmosphäre erzeugt, welche die Kupfer enthaltende Ausgangsverbindung enthält. Neben der gas-bzw. dampfförmigen Ausgangsverbindung kann gewünschtenfalls Inertgas oder Reaktivgas im Gasraum der Vorrichtung vorhanden sein.

In einer Variante wird die Ausgangsverbindung zusammen mit dem zu beschichtenden Substrat in die Vorrichtung eingebracht.

In einer alternativen, bevorzugten Variante wird zunächst nur das Substrat in die druckfeste Vorrichtung eingebracht und die bereits gas- bzw. dampfförmig vorliegende Ausgangsverbindung über eine besondere Leitung kontinuierlich oder diskontinuierlich in die Vorrichtung eingebracht. Auch hier kann ein Trägergas angewendet werden.

Die Überführung der Ausgangsverbindung in die Gas- bzw. Dampfphase kann man durch Erwärmen und gewünschtenfalls durch Zusatz eines Trägergases unterstützen.

Die Zersetzung erfolgt nach bekannten Methoden thermisch, durch Einwirkung eines Plasmas und/oder photolytisch.

Die thermische Zersetzung aus der Gas- bzw. Dampfphase führt man üblicherweise so durch, daß die Wände der Vorrichtung kalt gehalten werden und das Substrat auf eine Temperatur erhitzt wird, bei welcher sich die gewünschte Kupfer enthaltende Schicht auf dem Substrat abscheidet. Der Fachmann kann durch einfache orientierende Versuche für die jeweils eingesetzte Verbindung die notwendige Mindesttemperatur leicht bestimmen. Üblicherweise liegt die Temperatur, auf welche das Substrat erhitzt wird, oberhalb von etwa 150 °C.

Die Beheizung der Substrate kann in üblicher Weise erfolgen, beispielsweise durch Widerstandsheizung, Induktionsheizung, elektrische Heizeinrichtung wie Heizwendeln oder ähnlichem. Die Aufheizung der Substrate kann auch durch Strahlungsenergie induziert werden. Hierfür eignet sich insbesondere Laserstrahlungsenergie. Beispielsweise kann man Laser verwenden, die im Bereich des sichtbaren Lichtes, im UV-Bereich oder im IR-Bereich arbeiten. Laser besitzen den Vorteil, daß man sie mehr oder weniger fokussieren kann und daher gezielt bestimmte, begrenzte Bereiche oder Punkte des Substrats erhitzen kann.

Da das thermische CVD-Verfahren üblicherweise bei Unterdruck durchgeführt wird, ist es für den Fachmann selbstverständlich, druckfeste Apparaturen vorzusehen, wie sie in der Vakuumtechnik verwendet werden. Die Apparaturen weisen zweckmäßigerweise beheizbare Gasleitungen für die metallorganische Verbindung oder das Inertgas, absperrbare Öffnungen für Gasein- und Auslaß auf, gegebenenfalls Öffnungen zur Zuführung eines Träger- oder Reaktivgases, Temperaturmeßeinrichtungen, gewünschtenfalls eine Öffnung für die Zuführung der metallorganischen Verbindung, eine Einrichtung für die Aufheizung des Substrats muß vorhanden sein, eine zur Erzeugung des gewünschten Unterdruckes geeignete Pumpe etc. Für den Fall der Durchführung eines durch Strahlungsenergie induzierten CVD-Verfahrens muß auch noch eine Strahlungsquelle vorhanden sein, die Strahlung im Bereich des sichtbaren Lichtes, des Infrarot- oder Ultraviolett-Bereiches abgibt. Besonders geeignet sind entsprechende Laser-Strahlungsenergiequellen. Mittels der Strahlungsenergie kann das Substrat aufgeheizt werden.

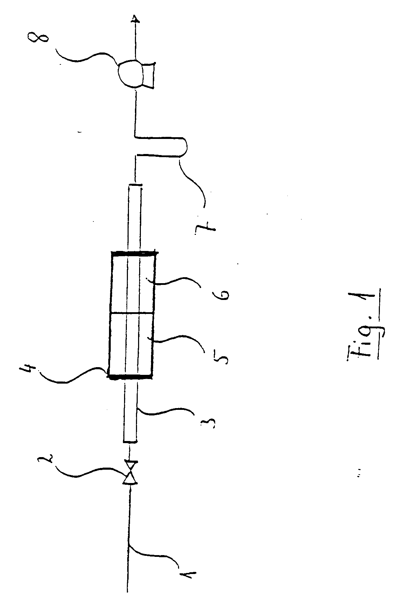

Eine sehr einfache, zweckmäßige Vorrichtung zur Verfahrensdurchführung ist in Fig. 1 wiedergegeben.

Sie umfaßt ein mit einer Inertgaszuleitung 1 über ein absperrbares Ventil 2 verbundenes Glasrohr 3, das konzentrisch in einem röhrenförmig aufgebauten Heizofen 4 angeordnet ist, welcher zwei Heizzonen 5 und 6 aufweist ("Zweizonenröhrenofen"). Die andere Seite des Rohres ist über eine Kühlfalle 7 mit einer Vakuumpumpe 8 verbunden.

In die erste Heizzone, die auf der Seite der Inertgaszuleitung liegt, wird die Ausgangsverbindung eingebracht. In die zweite Heizzone, die auf der Seite der Vakuumpumpe liegt, bringt man das Substrat ein.

Die plasmainduzierte Zersetzung führt man in einer schon vorstehend beschriebenen Apparatur durch.

Ohne daß hier eine Erklärung für die Bildung von Schichten durch Zersetzung der Kupferverbindungen gegeben werden soll, wird angenommen, daß Gase bzw. Dämpfe der Kupferverbindung auf das Substrat gelangen und dort unter Bildung der Kupfer enthaltenden Schichten zersetzt werden. Die Dicke der Schicht ist im wesentlichen abhängig vom Partialdruck, von der Zeitdauer, während welcher die Abscheidung durchgeführt wird, und von der Abscheidungstemperatur. Es lassen sich mehr oder weniger dünne Schichten erzeugen, beispielsweise Schichten mit einer Dicke von bis zu 20 Mikrometer, beispielsweise zwischen 100 Angström und 20 Mikrometer. Je nach gewünschter Schichtdicke kann der Fachmann durch orientierende Versuche die zur Erzeugung einer Kupfer enthaltenden Schicht bestimmter Dicke notwendige Zeitdauer und Abscheidungstemperatur bestimmen.

Wie schon gesagt, kann die Zersetzung auch photolytisch bewirkt werden, z.B. durch eine UV-Lampe oder durch einen mit geeigneter Wellenlänge arbeitenden Laser.

Die Anwendung eines Lasers ermöglicht beispielsweise die Reparatur von Leiterbahnen.

Der das Substrat umgebende Gasraum enthält die gas- bzw. dampfförmig vorliegende Ausgangsverbindung. Es wurde bereits weiter oben erwähnt, daß weiterhin ein Inertgas oder ein Reaktivgas in der Gasatmosphäre enthalten sein kann. Abhängig von der Art der Durchführung werden ganz unterschiedliche Kupfer enthaltende Schichten abgeschieden.

Zersetzt man die Ausgangsverbindung ohne Zusatz eines Inertgases oder eines Reaktivgases, so scheiden sich bei der Zersetzung, insbesondere bei der Durchführung als CVD-Verfahren, Schichten ab, die Kupfer im wesentlichen in metallischer Form enthalten.

Schichten, die bei thermischer Zersetzung insbesondere in einem thermischen CVD-Verfahren Kupfer im wesentlichen in metallischer Form enthalten, werden auch abgeschieden, wenn man in Anwesenheit eines Inertgases, beispielsweise in Anwesenheit von Edelgasen wie Argon arbeitet.

In einer anderen Ausführungsform führt man die Zersetzung in einer Reaktivgasatmosphäre durch. Eine solche reaktive Gasatmosphäre kann natürlich zusätzlich Inertgas enthalten, beispielsweise Edelgase wie Argon.

In einer Variante arbeitet man in einer reduzierenden Reaktivgasatmosphäre. Man führt die Zersetzung insbesondere nach Art eines thermischen oder plasmainduzierten CVD-Verfahrens durch. Die Zersetzung der Kupfer enthaltenden Ausgangsverbindung in einer reduzierenden Reaktivgasatmosphäre, welche insbesondere Wasserstoff enthält, ergibt Kupfer enthaltende Schichten, welche das Kupfer im wesentlichen in metallischer Form enthalten.

Eine Variante des erfindungsgemäßen Verfahrens ist dadurch gekennzeichnet, daß man zur Abscheidung von Kupfer enthaltenden Schichten, welche das Kupfer im wesentlichen in Form von Kupferoxid enthalten, die Zersetzung in Gegenwart einer reaktiven, hydrolysierenden und/oder oxidierenden Gasatmosphäre durchführt.

Zur Abscheidung von Kupfer enthaltenden Schichten, welche das Kupfer im wesentlichen in Form von Kupfer (I)-oxid enthalten, führt man die Zersetzung in Gegenwart insbesondere von Wasserdampf durch. Zur Abscheidung von Kupfer enthaltenden Schichten, welche das Kupfer im wesentlichen in Form von Kupfer(II)oxid enthalten, führt man die Zersetzung in Gegenwart einer oxidierenden Gasatmosphäre, insbesondere in Gegenwart von Sauerstoff, Ozon oder Distickstoffoxid durch.

Im erfindungsgemäßen Verfahren kann man im Prinzip beliebige Substrate beschichten, auf denen eine Beschichtung wünschenswert ist. Beispielsweise kann man anorganische Materialien, wie Metalle oder Metalllegierungen, z.B. Stahl, Halbleiter, Silicium, Isolatoren, Keramik, Glasphasen, oder organische Polymere, z.B. Polyphenylensulfid oder Polyimide, als Substrate verwenden.

Weiterhin kann man Substrate verwenden, die auch bei der Supraleiterherstellung verwendet werden, wie Kohlenstoff, insbesondere Kohlenstoffasern, oder beispielsweise Strontiumtitanat, Aluminiumoxid oder Magnesiumoxid.

Die Abscheidung von Schichten, die das Kupfer im wesentlichen in Form von metallischem Kupfer enthalten, ermöglicht beispielsweise unter Abdeckung bestimmter nicht zu beschichtender Bereiche nach an sich bekannten Strukturierungsverfahren die Erzeugung für den elektrischen Strom leitfähiger Leiterbahnen auf nichtleitenden Substraten, beispielsweise auf Keramik oder organischen Polymeren.

Das erfindungsgemäße Verfahren bietet dem Fachmann aber noch weitere Möglichkeiten. Es eignet sich beispielsweise auch zur Abscheidung von Schichten, welche neben dem Kupfer ein oder mehrere andere Metalle enthalten. Diese Ausführungsform des erfindungsgemäßen Verfahrens ist dadurch gekennzeichnet, daß man zur Abscheidung von Kupfer enthaltenden Schichten, welche weiterhin ein oder mehrere andere Metalle enthalten, eine oder mehrere Verbindungen anderer Metalle, insbesondere Verbindungen des Aluminiums, und eine Verbindung der allgemeinen Formel (I) gleichzeitig zersetzt. Es bilden sich dann Schichten, die Kupfer und ein oder mehrere andere Metalle in homogener Mischung enthalten und beständiger gegen Elektromigration sind. Die gleichzeitige Verdampfung und Zersetzung von Kupferverbindungen der allgemeinen Formel (I) und Aluminiumverbindungen, beispielsweise Di-i-butylaluminiumhydrid, oder Tri-i-butylaluminium eignet sich beispielsweise zur Herstellung elektromigrationsbeständiger Leiterbahnen. Auch bei dieser Ausführungsform kann man in inerter oder Reaktivgasatmosphäre arbeiten.

Weiterhin kann der Fachmann mehrere unterschiedliche Schichten sukzessive nacheinander auf Substraten aufbringen, wobei mindestens eine Schicht gemäß dem erfindungsgemäßen Verfahren erzeugt wird.

Weiterhin kann man durch gleichzeitige Verdampfung und Zersetzung von Kupferverbindungen der allgemeinen Formel (I) und entsprechenden anderen verdampfbaren Verbindungen in hydrolysierender und/oder oxidierender Atmosphäre Schichten abscheiden, die in ihrer Zusammensetzung bekannten oxidkeramischen Hochtemperatursupraleitern des Kuprat-Typs entsprechen. Man verwendet z.B. β-Diketonate von Yttrium, Barium, Strontium und anderen Metallen. Geeignet sind z.B. die entsprechenden Tetramethylheptandionate.

Weiterhin ist es möglich, zwei oder mehr unterschiedliche Schichten nacheinander abzuscheiden, wobei mindestens eine der Schichten nach dem erfindungsgemäßen Verfahren erzeugt worden ist.

Beispielsweise kann man zunächst eine die Haftung vermittelnde Titannitrid-Schicht nach bekannten Methoden, z.B. PVD- oder CVD-Verfahren, auf Substraten aufbringen. Anschließend zersetzt man eine Verbindung der allgemeinen Formel (I) zur Bildung von Leiterbahnen.

Ganz besonders eignet sich diese Ausführungsform des erfindungsgemäßen Verfahrens zur Beschichtung von Substraten mit oxidkeramischen Schichten, die in ihrer Zusammensetzung bekannten Hochtemperatursupraleitern des Kuprat-Typs entsprechen.

Substrate, die mit solchen Hochtemperatursupraleitern beschichtet werden, sind bekannt. Diese Substrate können beispielsweise in Form von Fasern, Bändern, Folien, Rohren, oder in Form von Platten ausgebildet sein.Man verwendet beispielsweise Kohlenstoffasern. Auf einen solchen Träger bringt man, wie vorstehend schon beschrieben, nach dem erfindungsgemäßen Verfahren unter Verwendung einer Verbindung der allgemeinen Formel (I) eine Schicht auf, die das Kupfer in Form von Kupferoxid enthält.

Die Abscheidung von Schichten, die die übrigen in bekannten oxidischen Supraleitern enthaltenen Metalle aufweisen, beispielsweise Yttrium und Barium zur Herstellung einer Zusammensetzung Y₁Ba₂Cu₃Oₓ, worin x einen Wert zwischen 6,8 und 6,95 aufweist, werden in bekannter Weise erzeugt. Beispielsweise kann man Komplexverbindungen von Yttrium und Barium mit β-Diketonaten, insbesondere 2,2,6,6-Tetramethylheptandion(3,5) verwenden. Man verdampft also beispielsweise Yttrium-tris-2,2,6,6-tetramethylheptandionat(3,5) bei Temperaturen zwischen Raumtemperatur und 500 °C und zersetzt diese Verbindung bei 500 °C bis 700 °C. Auf die nach dem erfindungsgemäßen Verfahren erzeugte Kupferoxid enthaltende Schicht wird dann eine Yttriumoxid enthaltende Schicht abgeschieden. Anschließend wird beispielsweise Barium-bis-2,2,6,6-tetramethylheptandionat(3,5) unter den gleichen Bedingungen verdampft und zersetzt. Die Reihenfolge kann verändert werden.

Zur Überführung in einen Yttrium-Barium-Kuprat-Hochtemperatursupraleiter wird die Beschichtung dann noch getempert.

In völlig analoger Weise können modifizierte oxidkeramische Schichten hergestellt werden, indem man einen Teil des Yttriums durch Strontium, Lanthan, Thallium, Wismut oder andere Metalle ersetzt, die zweckmäßig ebenfalls in Form der Metall-β-Diketonate, beispielsweise als Metall-2,2,6,6-Tetramethylheptandionat(3,5) eingesetzt werden.

Die Dicke der abgeschiedenen supraleitenden Schicht beträgt zweckmäßig von etwa 5 bis 20 Mikrometer.

Ein weiterer Gegenstand der vorliegenden Erfindung sind die neuen, im erfindungsgemäßen Verfahren einsetzbaren Verbindungen der allgemeinen Formel RO-Cu-L (I), worin R für 1-Arylniedrigalkyl, insbesondere Benzyl; für verzweigtes, gegebenenfalls substituiertes Alkyl mit 3 bis 6 C-Atomen; Aryl, insbesondere Phenyl, oder substituiertes Phenyl, insbesondere Tolyl oder Mesityl und L für (C1-C6-Alkyl)-isonitril, insbesondere verzweigtes Alkylisonitril mit 3 bis 5 C-Atomen in der Alkylkette, Arylisonitril, insbesondere Phenylisonitril oder Tolylisonitril, Kohlenmonoxid, Dialkylaminodifluorphosphan, Organyldifluorphosphan, insbesondere Phenyldifluorphosphan oder t-Butyldi fluorphosphan, Triarylphosphan oder Trialkylphosphan oder Trifluorphosphan oder Trichlorphosphan steht, mit Ausnahme von Verbindungen, in welchen R für t-Butyl und L für t-Butylisonitril, Kohlenmonoxid oder Triethylphosphan steht. Ausgenommen sind also die drei Verbindungen t-Butoxy-Kupfer-t-butylisonitril, t-Butoxy-Kupfer-Kohlen monoxid und t-Butoxykupfer-Triethylphosphan.

Bevorzugt sind Verbindungen, in welchen R für verzweigtes Alkyl mit 3 bis 5 C-Atomen, insbesondere i-Propyl, i-Butyl, t-Butyl oder neo-Pentyl, oder für verzweigtes, durch 1 oder mehr Fluoratome substituiertes Alkyl mit 3 bis 5 C-Atomen, insbesondere 2-Trifluormethylpropyl oder Per-fluor-t-butyl steht.

Besonders bevorzugt sind Verbindungen, in welchen L für t-Butylisonitril, Kohlenmonoxid, Triphenylphosphan oder Tri(niedrigalkyl)phosphan, insbesondere Trimethylphosphan oder Triethylphosphan, oder Trifluorphosphan steht.

Insbesondere bevorzugte Verbindungen sind t-Butoxy-Kupfer-t-Butyldifluorphosphan, t-Butoxy-Kupfer-phenyldifluorphosphan, t-Butoxy-Kupfer-diethylaminodifluorphosphan, 2-Trifluormethylpropan-2-oxy-Kupfer-t-butylisonitril, 2-Trifluormethylpropan-2-oxy-Kupfer-trimethylphosphan, Perfluor-t-Butoxy-Kupfer-t-butylisonitril, Perfluor-t-Butoxy-Kupfer-trimethylphosphan.

Im folgenden wird die Herstellung der Verbindungen der Formel RO-Cu-L (I) beschrieben.

Zur Herstellung der im erfindungsgemäßen Verfahren einsetzbaren Verbindungen der allgemeinen Formel RO-Cu-L (I) geht man aus von RO-Cu (II) als Zwischenprodukt, wobei R die vorstehende Bedeutung besitzt. Die Herstellung wird an einem bevorzugten Zwischenprodukt, t-Butoxy-Kupfer, t-BuO-Cu (III) weiter erläutert. Die Herstellung dieses Zwischenproduktes aus wasserfreiem Kupfer(I)chlorid und t-BuOLi in Tetrahydrofuran bei Raumtemperatur unter Inertgas beschreiben T. Tsuda, T. Hashimoto und T. Saegusa in J.A.C.S. 94 (1972), Seiten 658 und 659.

In analoger Weise wird Perfluor-t-butoxy-Kupfer (IV) und 2-Trifluormethylpropan-2-oxy-Kupfer (V) hergestellt. Zwischenprodukte mit anderen Resten R lassen sich analog herstellen.

Die auf diese Weise erhaltenen Zwischenprodukte der Formel (II), (III), (IV) oder (V) werden dann in einem aprotischen, unpolaren organischen Lösungsmittel wie Benzol oder Cyclohexan gelöst und mit der zweckmäßigerweise äquimolaren Menge des Liganden L versetzt, worauf sich die Verbindung der allgemeinen Formel RO-Cu-L (I) bildet.

Die Liganden L und ihre Herstellung sind bekannt. Einige dieser Liganden L sind Handelsprodukte, beispielsweise t-Butylisonitril, Trimethylphosphan, Triethylphosphan, Triphenylphosphan, Trifluor- oder Trichlorphosphan, oder Kohlenmonoxid.

Andere Liganden L können in bekannter Weise hergestellt werden.

Phenyldifluorphosphan und seine Herstellung wird beispielsweise von R. Schmutzler, Chem. Ber. 98 (1965), Seiten 552 bis 556 beschrieben. Man geht aus von Phenyldichlorphosphan, das seinerseits ein Handelsprodukt ist oder, siehe R. Schmutzler in Org. Syn. 45 (1965), Seiten 99 bis 101, aus der Anlagerung von Phosphorpentachlorid und Styrol und Reduktion mit Schwefeldioxid erhältlich ist. Phenyldichlorphosphan wird mit Natriumfluorid in Tetramethylensulfon umgesetzt und die Mischung auf 140 bis 180 °C erhitzt. Das gewünschte Phenyldifluorphosphan wird dann durch Destillation unter vermindertem Druck aus der Mischung isoliert.

Die Herstellung von t-Butyldifluorphosphan beschreiben M. Fild und R. Schmutzler in J. Chem. Soc. (A) 1970, Seiten 2359 bis 2364. Man geht aus von t-Butyldichlorphosphan, welches durch Umsetzung von Phosphortrichlorid mit t-Butylmagnesiumchlorid erhalten wird. Das Zwischenprodukt wird mit Antimontrifluorid bzw. Natriumfluorid in Sulfolan in das gewünschte t-Butyldifluorphosphan überführt und anschließend durch Destillation isoliert.

Die Herstellung anderer Organyldifluorphosphane erfolgt ebenfalls zweckmäßig aus den entsprechenden Organyldichlorphosphanen. Die Herstellung solcher Organyldichlorphosphane, wobei Organyl unsubstituiertes oder durch Halogen substituiertes Alkyl mit 1 bis 4 C-Atomen oder ggf. substituiertes Phenyl bedeutet, ist beispielsweise in Houben-Weyl, Methoden der organischen Chemie, Band XII/1, organische Phosphorverbindungen, Teil 1, Seite 302 bis 318 beschrieben. Insbesondere stellt man diese Verbindungen her, indem man Phosphortrichlorid mit Organometallverbindungen, beispielsweise Alkylquecksilber-, Alkylkadmium-, Alkylblei- oder Alkylaluminiumverbindungen bzw. entsprechenden Arylverbindungen umsetzt. Das erhaltene Organyldichlorphosphan wird dann mit Natriumfluorid oder Antimontrifluorid wie oben beschrieben fluoriert.

Die Alkylaminodifluorphosphan-Verbindungen und ihre Herstellung sind ebenfalls bekannt. Alkyl bedeutet hier Niedrigalkyl mit 1 bis 3 C-Atomen, insbesondere Methyl oder Ethyl. Der Begriff Dialkylamin umfaßt auch die Verbindung Piperidin. Zur Herstellung solcher Verbindungen kann man beispielsweise von den entsprechenden Dialkylaminodichlorphosphanen ausgehen und diese mit Antimontrifluorid oder Natriumfluorid in Sulfolan fluorieren, wie von R. Schmutzler in Inorg. Chem. 3 (1964), Seiten 415 bis 421 beschrieben. Die Dialkylaminodichlorphosphan-Verbindungen können aus Phosphortrichlorid und dem entsprechenden Dialkylamin hergestellt werden.

Ein weiterer Gegenstand der vorliegenden Erfindung sind die Verbindungen 2-Trifluormethylpropan-2-oxy-Kupfer und Perfluor-t-butoxy-Kupfer, welche wertvolle Zwischenprodukte für die Herstellung entsprechender erfindungsgemäßer Verbindungen der allgemeinen Formel RO-Cu-L (I) sind, worin R 2-Trifluormethylpropyl oder Perfluor-t-butyl ist.

Diese Zwischenprodukte werden wie vorstehend beschrieben hergestellt, indem man 2-Trifluormethylpropan-2-ol bzw. Perfluor-t-butanol mit n-Butyllithium in 2-Trifluormethylpropan-2-oxy-lithium bzw. Perfluor-t-butoxy-lithium überführt und dann mit Cu(I)Cl zum gewünschten Zwischenprodukt umsetzt.

Die erfindungsgemäß einsetzbaren Verbindungen weisen im Vergleich mit bereits bekannten Verbindungen bei der Anwendung wesentliche Vorteile auf, z.B. sind sie bei Raumtemperatur besser handhabbar, sie sind leichter zugänglich und sie weisen eine niedrigere Zersetzungstemperatur auf. Damit ist die schonendere Abscheidung von Kupfer enthaltenen Schichten auch auf temperaturempfindlichen Substraten möglich. Isonitrilverbindungen sind aufgrund der leichten photolytischen Zersetzbarkeit besonders vorteilhaft.

Die folgenden Beispiele sollen die Erfindung weiter erläutern, ohne sie in ihrem Umfang einzuschränken.

### Beispiel 1:

### Herstellung von t-BuO-Cu

Die Herstellung erfolgte wie von T. Tsuda et. al. in Inorg. Chem. 15 (1976), Seiten 2331 bis 2332 beschrieben.

Die Herstellung erfolgte unmittelbar in einer Sublimationsapparatur. 5.0 g wasserfreies Cu(I)Cl und 3.7 g Lithium-t-butoxid wurden in 50 ml getrocknetem, sauerstofffreiem Tetrahydrofuran gelöst und bei Umgebungstemperatur unter Stickstoffatmosphäre über Nacht gerührt. Das Lösungsmittel wurde bei vermindertem Druck abgedampft und der verbleibende Feststoff der Sublimation bei 17 °C und 0,8 mm unterworfen. Ausbeute: etwa 5 g gelbe Kristalle von t-Butoxy-Kupfer.

Zur Gewinnung größerer Mengen dieser Verbindung wurde der Versuch mehrfach wiederholt.

### Beispiel 2:

### Herstellung von 2-trifluormethylpropan-2-oxy-Kupfer

5 g 2-Trifluormethylpropan-2-ol wurde mit der äquimolaren Menge Lithium-t-butoxid lithiiert und das Reaktionsprodukt in 50 ml wasserfreiem, sauerstofffreiem Tetrahydrofuran gelöst. Die Lösung wurde mit der äquimolaren Menge Cu(I)Cl versetzt und über Nacht bei Umgebungstemperatur unter Stickstoffatmosphäre gerührt. Das ausgefallene Lithiumchlorid wurde abfiltriert und flüchtige Bestandteile abgedampft. Die Ausbeute an 2-Trifluormethylpropan-2-oxy-Kupfer war quantitativ.
- 1H-NMR-Spektrum:: 1,29 ppm (Singulett)
- 19F-NMR-Spektrum:: -84,79 ppm
- IR-Spektrum (Nujol):: 1134 cm⁻¹, 1047 cm⁻¹, 1007 cm⁻¹, 611 cm⁻¹ und 509 cm⁻¹

### Beispiel 3:

### Herstellung von Perfluor-t-butoxy-Kupfer

Die Herstellung dieser Verbindung erfolgte analog der in Beispiel 2 beschriebenen Herstellung der Trifluormethylpropoxy-Verbindung.

### Beispiel 4:

### Herstellung von t-BuO-Cu-CO

Die Herstellung erfolgte wie von T. Tsuda et.al. in J. Am. Chem. Soc. 96 (1974), Seiten 5930 und 5931 beschrieben.

4.5 g des gemäß Beispiel 1 hergestellten t-BuO-Cu wurden in Benzol suspendiert und Kohlenmonoxid bei Raumtemperatur durchgeleitet. Nachdem der Feststoff vollständig in Lösung gegangen war, wurde filtriert, das Benzol abgedampft und der verbleibende Feststoff bei 60 °C (1 mm) sublimiert. Ausbeute an t-BuO-Cu-CO: etwa 75 % der Theorie.

### Beispiel 5:

### Herstellung von t-BuO-Cu-t-BuNC

Die Herstellung erfolgte wie von T. Tsuda et.al. in J. Am. Chem. Soc. 96 (1974), Seiten 5930 und 5931 beschrieben. 4.5 g des gemäß Beispiel 1 hergestellten t-BuO-Cu wurde in Benzol suspendiert und eine äquimolare Menge t-BuNC zugegeben. Das Lösungsmittel wurde abgedampft und der verbleibende Feststoff bei 90 °C (1 mm) sublimiert. Ausbeute an t-BuO-Cu-t-BuNC: etwa 75 % der Theorie.

### Beispiel 6:

### Herstellung von t-BuO-Cu-PEt₃

Die Herstellung erfolgte wie von T. Tsuda et.al. in J. Am. Chem. Soc. 94 (1972), Seiten 658 und 659 beschrieben.

4.3 g des gemäß Beispiel 1 hergstellten t-BuO-Cu wurde in Benzol suspendiert und eine äquimolare Menge an Triethylphosphan zugegeben. Das Lösungsmittel wurde abgedampft und der verbleibende Feststoff bei 100 °C (1 mm) sublimiert. Ausbeute: etwa 80 % der Theorie.

### Beispiel 7:

### Herstellung von 2-trifluormethylpropan-2-oxy-Kupfer-t-butylisonitril

3.5 g des gemäß Beispiel 2 hergestellten 2-Trifluormethylpropan-2-oxy-Kupfer wurden in Benzol mit der äquimolaren Menge an t-Butylisonitril versetzt. Es wurde weitergerührt, bis sich der suspendierte Feststoff völlig aufgelöst hatte. Danach wurden leicht flüchtige Bestandteile abgedampft. Die Ausbeute an 2-Trifluormethylpropan-2-oxy-Kupfer-t-butylisonitril war annähernd quantitativ.
- 1H-NMR-Spektrum:: 1,29 ppm O-C(CH₃)₂(CF₃)
1,45 ppm C(CH₃)
- 19F-NMR-Spektrum:: -84,67 ppm (CF₃)
- IR-Spektrum (Nujol):: 2176 cm⁻¹
1369 cm⁻¹
1240 cm⁻¹
1192 cm⁻¹

Das Produkt kann durch Sublimation weiter gereinigt werden. Ausbeute nach Sublimation: etwa 80 % der Theorie.

### Beispiel 8:

### Herstellung von 2-Trifluormethylpropan-2-oxy-Kupfer-trimethylphosphan

4.8 g des gemäß Beispiel 2 hergestellten 2-Trifluormethylpropan-2-oxy-Kupfer wurde in Benzol suspendiert und mit der äquimolaren Menge Trimethylphosphan versetzt. Nachdem der Feststoff in Lösung gegangen war, wurde das Lösungsmittel abgedampft. Die Verbindung 2-Trifluormethylpropan-2-oxy-Kupfer-trimethylphosphan, ein Feststoff, wurde in annähernd quantitativer Ausbeute isoliert.
- 1H-NMR-Spektrum:: 1,29 ppm -O-C(CH₃)₂(CF₃)
1,21-1,23 ppm -C(CH₃)₃
- 19F-NMR-Spektrum:: -84,69 ppm (CF₃)
- 31P-NMR-Spektrum:: -45,89 ppm
- IR-Spektrum (KBr-Preßling):: 2963 cm⁻¹
2901 cm⁻¹
1425 cm⁻¹
951 cm⁻¹
727 cm⁻¹

Gewünschtenfalls kann die Verbindung durch Sublimation weiter gereinigt werden. Ausbeute nach Sublimation: etwa 70 % der Theorie.

### Beispiel 9:

Anwendung von Verbindungen der allgemeinen Formel (I) zur Abscheidung Kupfer enthaltender Schichten

Verwendet wurde eine entsprechend Fig. 1 aufgebaute Vorrichtung.

Ein Quarzglasrohr war konzentrisch in einen 2-Zonenröhrenofen eingebracht. Die eine Seite des Quarzrohres war absperrbar mit einer Inertgasleitung verbunden, die andere Seite mit einer Vakuumpumpe. Zwischen Quarzrohr und Vakuumpumpe befand sich eine tiefkühlbare Falle zur Abtrennung flüchtiger Bestandteile aus dem abgepumpten Gasstrom.

Die zu verdampfende metallorganische Verbindung wurde in einem Porzellanschiffchen in das Glasrohr in der 1. Heizzone des 2-Zonenröhrenofens positioniert. Das Substrat wurde in die 2. Heizzone eingebracht. In einem Anwendungsbeispiel diente die Glasrohrwand in der 2. Heizzone gleichzeitig als Substrat.

### 9.2. Versuchsdurchführung

### 9.2.1. Anwendung von Glas als Substrat

Als Substrat fungierte die Quarzglasrohrwand. Als Ausgangsverbindung wurde das gemäß Beispiel 5 hergestellte t-BuO-Cu-t-BuNC eingesetzt.

Die Heizzone 2 wurde auf etwa 400 ° C gebracht. Der Druck betrug etwa 1 mbar. Die in das Quarzrohr eingebrachte Ausgangsverbindung wurde auf 110 ° C erwärmt. Die Ausgangsverbindung trat in die Gasatmosphäre über und wurde unter Einleiten eines Stickstoffstroms (etwa 25 ml/min) in das Quarzrohr durch das Quarzrohr geleitet. Nach etwa 30 Minuten wurde die Abscheidung beendet und über die Inertgasleitung das Glasrohr mit gereinigtem Stickstoff auf Normaldruck gebracht. Auf dem Glasrohr in der Heizzone 2 hatte sich eine Kupferschicht abgeschieden.

### 9.2.2. Anwendung von Polyimid als Substrat

Als Ausgangsverbindung wurde das gemäß Beispiel 4 hergestellte t-BuO-Cu-CO verwendet. Die Versuchsdurchführung erfolgte wie unter 9.2.1. beschrieben. Das Substrat wurde in Heizzone 2 eingebracht. Die Temperatur in Heizzone 1 wurde auf 60 °C und in Heizzone 2 wurde auf 400 °C eingeregelt. Nach der Entnahme der Probe aus dem Quarzrohr konnte festgestellt werden, daß wiederum eine sehr gut haftende Kupferschicht auf dem Polyimid gebildet worden war.

### 9.2.3. Anwendung von Polyimid als Substrat

Als Ausgangsverbindung diente das gemäß Beispiel 6 hergestellte t-BuO-Cu-PEt₃. Die Versuchsdurchführung erfolgte wie unter 9.2.2. beschrieben. Die Temperatur in Heizzone 1 wurde auf 120 °C und in Heizzone 2 auf 400 °C eingeregelt. Nach der Entnahme der Probe aus dem Quarzrohr konnte festgestellt werden, daß wiederum eine sehr gut haftende Kupferschicht auf dem Polyimid gebildet worden war.

### 9.2.4. Anwendung von Siliciumscheiben als Substrat

Ausgangsverbindung war das gemäß Beispiel 7 hergestellten 2-Trifluormethylpropan-2-oxy-Kupfer-t-butyl-isonitril. Die Versuchsdurchführung erfolgte wie unter 9.2.2. beschrieben. Die Temperatur in Heizzone 1 wurde auf 115 °C und in Heizzone 2 auf 400 °C eingeregelt. Nach der Entnahme der Probe aus dem Quarzrohr konnte festgestellt werden, daß eine sehr gut haftende Kupferschicht auf den Siliciumscheiben gebildet worden war.

### 9.2.5. Anwendung von Polyimid als Substrat

Ausgangsverbindung war das gemäß Beispiel 8 hergestellte 2-Trifluormethylpropan-2-oxy-Kupfer-trimethylphosphan. Die Versuchsdurchführung erfolgte wie unter 9.2.2. beschrieben. Die Temperatur in Heizzone 1 wurde auf 125 °C und in Heizzone 2 auf 400 °C eingeregelt. Nach der Entnahme der Probe aus dem Quarzrohr konnte festgestellt werden, daß wiederum eine sehr gut haftende Kupferschicht auf dem Polyimid gebildet worden war.

## Patentansprüche

1. Verfahren zur Abscheidung einer Kupfer enthaltenden Schicht auf einem Substrat, dadurch gekennzeichnet, daß man durch Zersetzung einer Verbindung der allgemeinen Formel RO-Cu-L (I), worin R für 1-Arylniedrigalkyl, insbesondere Benzyl; für verzweigtes, gegebenenfalls substituiertes Alkyl mit 3 bis 6 C-Atomen; Aryl, insbesondere Phenyl, oder substituiertes Phenyl, insbesondere Tolyl oder Mesityl und L für (C1-C6-Alkyl)-isonitril, insbesondere verzweigtes Alkylisonitril mit 3 bis 5 C-Atomen in der Alkylkette oder Arylisonitril, insbesondere Phenylisonitril oder Tolylisonitril, Kohlenmonoxid, Dialkylaminodifluorphosphan, Organyldifluorphosphan, insbesondere Phenyldifluorphosphan oder t-Butyldifluorphosphan, Triarylphosphan oder Trialkylphosphan oder Trifluorphosphan oder Trichlorphosphan steht, eine Kupfer enthaltende Schicht auf dem Substrat aufbringt.

2. Verfahren nach Anspruch 1, dadurch gekennzeichnet, daß R für verzweigtes Alkyl mit 3 bis 5 C-Atomen, insbesondere i-Propyl, i-Butyl, t-Butyl oder neo-Pentyl, oder für verzweigtes, durch 1 oder mehr Fluoratome substituiertes Alkyl mit 3 bis 5 C-Atomen, insbesondere 2-Trifluormethylpropyl oder Perfluor-t-butyl steht.

3. Verfahren nach Anspruch 1 oder 2, dadurch gekennzeichnet, daß L für t-Butylisonitril, Kohlenmonoxid, Triphenylphosphan oder Tri(niedrigalkyl)phosphan, insbesondere Trimethylphosphan oder Triethylphosphan, oder Trifluorphosphan steht.

4. Verfahren nach Anspruch 1, 2 oder 3, dadurch gekennzeichnet, daß man die Verbindung der allgemeinen Formel (I) in der Dampfphase zersetzt.

5. Verfahren nach einem der vorhergehenden Ansprüche, dadurch gekennzeichnet, daß man die Zersetzung thermisch oder mittels Strahlungsenergie, insbesondere Laserstrahlungsenergie, bewirkt.

6. Verfahren nach Anspruch 5, dadurch gekennzeichnet, daß man die Zersetzung der Verbindung der allgemeinen Formel (I) thermisch durch Aufheizen des Substrats auf Temperaturen oberhalb von etwa 150 °C bewirkt.

7. Verfahren nach einem der vorhergehenden Ansprüche, dadurch gekennzeichnet, daß man die Verbindung der allgemeinen Formel (I) unter vermindertem Druck, gewünschtenfalls unter Anwendung eines Trägergases, in die Dampfphase überführt und unter vermindertem Druck zersetzt.

8. Verfahren nach einem der vorhergehenden Ansprüche, dadurch gekennzeichnet, daß man zur Abscheidung von Kupfer enthaltenden Schichten, welche das Kupfer im wesentlichen in Form von metallischen Kupfer enthalten, die Zersetzung in einer inerten Gasatmosphäre oder in Anwesenheit einer reduzierend wirkenden Gasatmosphäre durchführt.

9. Verfahren nach einem der Ansprüche 1 bis 7, dadurch gekennzeichnet, daß man zur Abscheidung von Kupfer enthaltenden Schichten, welche das Kupfer im wesentlichen in Form von Kupferoxid enthalten, die Zersetzung in Gegenwart einer reaktiven oxidierenden und/oder hydrolysierenden Gasatmosphäre durchführt.

10. Verfahren nach einem der vorhergehenden Ansprüche, dadurch gekennzeichnet, daß man zur Abscheidung von Kupfer und ein oder mehrere weitere Metalle enthaltenden Schichten auf dem Substrat eine Verbindung der allgemeinen Formel (I) und eine oder mehrere Verbindungen anderer Metalle, insbesondere Aluminiumverbindungen, gleichzeitig oder nacheinander zersetzt.

11. Verfahren nach einem der vorhergehenden Ansprüche, dadurch gekennzeichnet, daß man mehrere unterschiedliche Schichten nacheinander abscheidet.

12. Verfahren nach einem der vorhergehenden Ansprüche, dadurch gekennzeichnet, daß man als Substrat anorganische Materialien, bevorzugt Metalle, Halbleiter, Isolatoren, Keramik, Glasphasen, oder organische Polymere, z.B. Polyphenylensulfid, Polyimid, oder Kohlenstoff, z.B. Kohlenstofffasern verwendet.

13. Verbindungen der allgemeinen Formel RO-Cu-L(I), worin R für 1-Arylniedrigalkyl, insbesondere Benzyl; für verzweigtes, gegebenenfalls substituiertes Alkyl mit 3 bis 6 C-Atomen; Aryl, insbesondere Phenyl, oder substituiertes Phenyl, insbesondere Tolyl oder Mesityl und L für (C1-C6-Alkyl)-isonitril, insbesondere verzweigtes Alkylisonitril mit 3 bis 5 C-Atomen in der Alkylkette, Arylisonitril, insbesondere Phenylisonitril oder Tolylisonitril, Kohlenmonoxid, Dialkylaminodifluorphosphan, Organyldifluorphosphan, insbesondere Phenyldifluorphosphan oder t-Butyldifluorphosphan, Triarylphosphan oder Trialkylphosphan oder Trifluorphosphan oder Trichlorphosphan, mit Ausnahme von Verbindungen, in welchen R für t-Butyl und L für t-Butylisonitril, Kohlenmonoxid oder Triethylphosphan steht.

14. Verbindungen nach Anspruch 13, worin R für verzweigtes Alkyl mit 3 bis 5 C-Atomen, insbesondere i-Propyl, i-Butyl, t-Butyl oder neo-Pentyl, oder für verzweigtes, durch 1 oder mehr Fluoratome substituiertes Alkyl mit 3 bis 5 C-Atomen, insbesondere 2-Trifluormethylpropyl oder Per-fluor-t-butyl steht.

15. Verbindungen nach Anspruch 13 oder 14, worin L für t-Butylisonitril, Kohlenmonoxid, Triphenylphosphan oder Tri(niedrigalkyl)phosphan, insbesondere Trimethylphosphan oder Triethylphosphan, oder Trifluorphosphan steht.

16. Die Verbindungen t-Butoxy-Kupfer-t-Butyldifluorphosphan, t-Butoxy-Kupfer-phenyldifluorphosphan, t-Butoxy-Kupfer-diethylaminodifluorphosphan, 2-Trifluormethylpropan-2-oxy-Kupfer-t-Butylisonitril, 2-Trifluormethylpropan-2-oxy-Kupfer-trimethylphosphan, Perfluor-t-Butoxy-Kupfer-t-Butylisonitril, Perfluor-t-Butoxy-Kupfer-trimethylphosphan.

17. 2-Trifluormethylpropan-2-oxy-kupfer, Perfluor-t-butoxy-kupfer als Zwischenprodukte.

## Claims

1. Process for depositing a copper-containing layer on a substrate, characterised in that a copper-containing layer is applied to the substrate by decomposing a compound of the general formula RO-Cu-L (I), wherein R stands for 1-aryl lower alkyl, in particular benzyl; for branched, optionally substituted alkyl with 3 to 6 C atoms; aryl, in particular phenyl, or substituted phenyl, in particular tolyl or mesityl, and L stands for (C1-C6-alkyl)isonitrile, in particular branched alkyl isonitrile with 3 to 5 C atoms in the alkyl chain, or aryl isonitrile, in particular phenyl isonitrile or tolyl isonitrile, carbon monoxide, dialkylaminodifluorophosphane, organyl difluorophosphane, in particular phenyl difluorophosphane or t-butyl difluorophosphane, triaryl phosphane or trialkyl phosphane or trifluorophosphane or trichlorophosphane.

2. Process according to Claim 1, characterised in that R stands for branched alkyl with 3 to 5 C atoms, in particular i-propyl, i-butyl, t-butyl or neo-pentyl, or for branched alkyl with 3 to 5 C atoms and substituted by 1 or more fluorine atoms, in particular 2-trifluoromethylpropyl or perfluoro-t-butyl.

3. Process according to Claim 1 or 2, characterised in that L stands for t-butyl isonitrile, carbon monoxide, triphenylphosphane or tri(lower alkyl)phosphane, in particular trimethylphosphane or triethylphosphane, or trifluorophosphane.

4. Process according to Claim 1, 2 or 3, characterised in that the compound of the general formula (I) is decomposed in the vapour phase.

5. Process according to one of the preceding Claims, characterised in that the decomposition is brought about thermally or by means of radiation energy, in particular laser radiation energy.

6. Process according to Claim 5, characterised in that the decomposition of the compound of the general formula (I) is brought about thermally by heating the substrate to temperatures above about 150°C.

7. Process according to one of the preceding Claims, characterised in that the compound of the general Formula (I) is converted into the vapour phase under reduced pressure, if desired using a carrier gas, and is decomposed under reduced pressure.

8. Process according to one of the preceding Claims, characterised in that for depositing copper-containing layers which contain the copper substantially in the form of metallic copper, the decomposition is carried out in an inert gas atmosphere or in the presence of a gas atmosphere which has a reducing effect.

9. Process according to one of Claims 1 to 7, characterised in that for depositing copper-containing layers which contain the copper substantially in the form of copper oxide, the decomposition is carried out in the presence of a reactive oxidising and/or hydrolysing gas atmosphere.

10. Process according to one of the preceding Claims, characterised in that for depositing layers containing copper and one or more other metals on the substrate, a compound of the general formula (I) and one or more compounds of other metals, in particular aluminium compounds, are decomposed at the same time or successively.

11. Process according to one of the preceding claims, characterised in that a plurality of different layers are deposited successively.

12. Process according to one of the preceding Claims, characterised in that inorganic materials, preferably metals, semiconductors, insulators, ceramics, glass phases, or organic polymers, e.g. polyphenylene sulphide, polyimide, or carbon, e.g. carbon fibres, are used as the substrate.

13. Compounds of the general formula RO-Cu-L (I), wherein R stands for 1-aryl lower alkyl, in particular benzyl; for branched, optionally substituted alkyl with 3 to 6 C atoms; aryl, in particular phenyl, or substituted phenyl, in particular tolyl or mesityl, and L stands for (C1-C6-alkyl)isonitrile, in particular branched alkyl isonitrile with 3 to 5 C atoms in the alkyl chain, aryl isonitrile, in particular phenyl isonitrile or tolyl isonitrile, carbon monoxide, dialkylaminodifluorophosphane, organyl difluorophosphane, in particular phenyl difluorophosphane or t-butyl difluorophosphane, triaryl phosphane or trialkyl phosphane or trifluorophosphane or trichlorophosphane, with the exception of compounds in which R stands for t-butyl and L for t-butyl isonitrile, carbon monoxide or triethylphosphane.

14. Compounds according to Claim 13, wherein R stands for branched alkyl with 3 to 5 C atoms, in particular i-propyl, i-butyl, t-butyl or neo-pentyl, or for branched alkyl with 3 to 5 C atoms and substituted by 1 or more fluorine atoms, in particular 2-trifluoromethylpropyl or perfluoro-t-butyl.

15. Compounds according to Claim 13 or 14, wherein L stands for t-butyl isonitrile, carbon monoxide, triphenylphosphane or tri(lower alkyl)phosphane, in particular trimethylphosphane or triethylphosphane, or trifluorophosphane.

16. The compounds t-butoxy-copper-t-butyl difluorophosphane, t-butoxy-copper-phenyl difluorophosphane, t-butoxy-copper-diethylaminodifluorophosphane, 2-trifluoromethylpropan-2-oxy-copper-t-butyl isonitrile, 2-trifluoromethylpropan-2-oxy-copper-trimethylphosphane, perfluoro-t-butoxy-copper-t-butyl isonitrile, perfluoro-t-butoxy-copper-trimethylphosphane.

17. 2-trifluoromethylpropan-2-oxy-copper, perfluoro-t-butoxy-copper as intermediate products.

## Revendications

1. Procédé pour déposer une couche contenant du cuivre sur un substrat, caractérisé en ce qu'on applique sur le substrat une couche contenant du cuivre, par décomposition d'un composé de formule générale RO-Cu-L (I), dans laquelle R est un groupe 1-aryl-(alkyl inférieur), en particulier benzyle ; un radical alkyle ramifié éventuellement substitué ayant de 3 à 6 atomes de carbone ; aryle, en particulier phényle, ou phényle substitué, en particulier tolyle ou mésityle, et L est un composé (alkyl en C₁-C₆)-isonitrile, en particulier un alkylisonitrile ramifié ayant de 3 à 5 atomes de carbone dans la chaîne alkyle, ou encore arylisonitrile, en particulier phénylisonitrile ou tolylisonitrile, le monoxyde de carbone, un dialkylaminodifluorophosphane, un organyldifluorophosphane, en particulier le phényldifluorophosphane ou le tert-butyldifluorophosphane, un triarylphosphane ou un trialkylphosphane ou le trifluorophosphane ou le trichlorophosphane.

2. Procédé selon la revendication 1, caractérisé en ce que R est un radical alkyle ramifié ayant de 3 à 5 atomes de carbone, en particulier le radical isopropyle, isobutyle, tert-butyle ou néopentyle, ou encore un radical alkyle ramifié, substitué par au moins un atome de fluor et ayant de 3 à 5 atomes de carbone, en particulier le radical 2-trifluorométhylpropyle ou perfluoro-tert-butyle.

3. Procédé selon la revendication 1 ou 2, caractérisé en ce que L est le tert-butylisonitrile, le monoxyde de carbone, le triphénylphosphane ou un tri(alkyl inférieur)phosphane, en particulier le triméthylphosphane ou le triéthylphosphane, ou le trifluorophosphane.

4. Procédé selon la revendication 1, 2 ou 3, caractérisé en ce qu'on décompose le composé de formule générale (I) en phase vapeur.

5. Procédé selon l'une des revendications précédentes, caractérisé en ce qu'on procède à la décomposition par voie thermique ou à l'aide d'une énergie rayonnante, notamment l'énergie d'un rayonnement laser.

6. Procédé selon la revendication 5, caractérisé en ce qu'on procède à la décomposition du composé de formule générale (I) par voie thermique, par chauffage du substrat à des températures supérieures à environ 150°C.

7. Procédé selon l'une des revendications précédentes, caractérisé en ce qu'on convertit en une phase vapeur le composé de formule générale (I), sous pression réduite, avantageusement par utilisation d'un gaz porteur, et on le décompose sous pression réduite.

8. Procédé selon l'une des revendications précédentes, caractérisé en ce que, pour déposer des couches contenant du cuivre, qui contiennent le cuivre essentiellement sous forme de cuivre métallique, on procède à la décomposition dans une atmosphère d'un gaz inerte ou en présence d'une atmosphère gazeuse à effet réducteur.

9. Procédé selon l'une des revendications 1 à 7, caractérisé en ce que, pour déposer des couches contenant du cuivre, qui contiennent le cuivre essentiellement sous forme d'oxyde de cuivre, on procède à la décomposition en présence d'une atmosphère gazeuse réactive, oxydante et/ou hydrolysante.

10. Procédé selon l'une des revendications précédentes, caractérisé en ce que, pour déposer sur le substrat des couches contenant du cuivre et un ou plusieurs autres métaux, on décompose, simultanément ou successivement, un composé de formule générale (I) et un ou plusieurs composés d'autres métaux, en particulier des composés de l'aluminium.

11. Procédé selon l'une des revendications précédentes, caractérisé en ce qu'on dépose successivement plusieurs couches différentes.

12. Procédé selon l'une des revendications précédentes, caractérisé en ce qu'on utilise comme substrat des matériaux minéraux, de préférence des métaux, des semi-conducteurs, des isolants, des céramiques, des phases vitreuses ou des polymères organiques, par exemple du poly(sulfure de phénylène), un polyimide, ou du carbone, par exemple des fibres de carbone.

13. Composés de formule générale RO-Cu-L (I), dans laquelle R est un groupe 1-aryl-(alkyl inférieur), en particulier benzyle ; un radical alkyle ramifié éventuellement substitué ayant de 3 à 6 atomes de carbone ; aryle, en particulier phényle, ou phényle substitué, en particulier tolyle ou mésityle, et L est un composé (alkyl en C₁-C₆)-isonitrile, en particulier un radical alkylisonitrile ramifié ayant de 3 à 5 atomes de carbone dans la chaîne alkyle, ou encore arylisonitrile, en particulier phénylisonitrile ou tolylisonitrile, le monoxyde de carbone, un dialkylaminodifluorophosphane, un organyldifluorophosphane, en particulier le phényldifluorophosphane ou le tert-butyldifluorophosphane, un triarylphosphane ou un trialkylphosphane ou encore le trifluorophosphane ou le trichlorophosphane, à l'exception des composés dans lesquels R est le radical tert-butyle et L est le tert-butylisonitrile, le monoxyde de carbone ou le triéthylphosphane.

14. Composés selon la revendication 13, dans lesquels R est un radical alkyle ramifié ayant de 3 à 5 atomes de carbone, en particulier le radical isopropyle, isobutyle, tert-butyle ou néopentyle, ou encore un radical alkyle ramifié, substitué par au moins un atome de fluor et ayant de 3 à 5 atomes de carbone, en particulier le radical 2-trifluorométhylpropyle ou perfluoro-tert-butyle.

15. Composés selon la revendication 13 ou 14, dans lesquels L est le tert-butylisonitrile, le monoxyde de carbone, le triphénylphosphane ou un tri(alkyl inférieur)phosphane, en particulier le triméthylphosphane ou le triéthylphosphane, ou encore le trifluorophosphane.

16. Les composés tert-butoxy-cuivre-tert-butyldifluorophosphane, tert-butoxy-cuivre-phényldifluorophosphane, tert-butoxy-cuivre-diéthylaminodifluorophosphane, 2-trifluorométhylpropane-2-oxy-cuivre-tert-butylisonitrile, 2-trifluorométhylpropane-2-oxy-cuivre-triméthylphosphane, perfluoro-tert-butoxy-cuivre-tert-butylisonitrile, perfluoro-tert-butoxy-cuivre-triméthylphosphane.

17. 2-trifluorométhylpropane-2-oxy-cuivre, perfluoro-tert-butoxy-cuivre servant de produits intermédiaires.
